# EUROPEAN PATENT SPECIFICATION

(11) **EP 4 199 671 B1**
(45) Date of publication and mention of the grant of the patent: **07.05.2025**
(21) Application number: 21930958.0
(22) Date of filing: 31.03.2021
(51) Int. Cl.: H05K 7/20, H01L 23/473, H01G 2/08, H01G 2/04, H01G 2/10

(54) **CAPACITOR AND POWER DEVICE ASSEMBLY HAVING COOLING STRUCTURE**
KONDENSATOR UND LEISTUNGSVORRICHTUNGSANORDNUNG MIT KÜHLSTRUKTUR
CONDENSATEUR ET ENSEMBLE DISPOSITIF D'ALIMENTATION AYANT UNE STRUCTURE DE REFROIDISSEMENT

(30) Priority: 19.03.2021 CN 202120567315 U
(43) Date of publication of application: 21.06.2023
(73) Proprietor: Jing-Jin Electric Technologies Co., Ltd., Beijing 100015 (CN)
(72) Inventor: ZHANG, Hao, Beijing 100015 (CN); LOPEZ, Gabriel Gallegos, Beijing 100015 (CN)
(74) Representative: Savi, Massimiliano
(86) International application number: PCT/CN2021/084517
(87) International publication number: WO 2022/193370

(56) References cited:
- CN-A- 103 687 439
- CN-A- 109 757 076
- CN-U- 201 594 787
- CN-U- 206 685 367
- JP-A- H0 919 163
- US-A1- 2003 067 748
- US-A1- 2008 117 602
- US-A1- 2014 063 741
- US-A1- 2019 275 895

## Description

### TECHNICAL FIELD

The present disclosure belongs to the technical field of motor controllers, and more specifically, relates to a capacitor and power device assembly having a cooling structure.

### BACKGROUND

The motor controller is an integrated circuit that actively controls the motor to work according to the preset direction, speed, angle and response time. The motor controller inevitably generates heat during work. However, the temperature tolerance of the capacitor in the motor controller is limited. In order to ensure the performance of the capacitor under high ambient temperature, the capacitor needs to be cooled. At present, the capacitor dissipates heat mainly by contacting other parts, and the heat dissipation efficiency is low.

At the same time, due to the increasing power density requirements of motor controllers, it is necessary to increase the number or power of power modules. Each power module needs to dissipate heat and needs enough space for layout.

Prior art heat dissipation layouts are disclosed in documents US2014/063741 A1, US2019/275895 A1, US2008/117602 A1 and JPH0919163 A.

### SUMMARY

In view of the above problems, the present disclosure discloses a capacitor and power device assembly having a cooling structure as recited in claim 1. Further embodiments are recited in the dependent claims.

The advantages and beneficial effects of the present disclosure are as follows.

The cooling structure in the present disclosure adopts the liquid cooling mode. By providing the first cooling passage on both sides of the capacitor, the double side cooling of the capacitor is realized, and the cooling efficiency is high. Moreover, the cooling structure is also provided with a second cooling passage for cooling the power devices, so that the capacitor and power devices can be cooled simultaneously, the space occupied is small, and the structure is compact.

### BRIEF DESCRIPTION OF DRAWINGS

By reading the detailed description of the preferred embodiments below, various other advantages and benefits will become clear to a person of ordinary skill in the art. The accompanying drawings are only used for the purpose of illustrating the preferred embodiments, and should not be considered as a limitation to the present disclosure. Moreover, throughout the drawings, the same reference numerals are used to denote the same components. In the drawings:
FIG. 1 is a perspective view of a capacitor and power device assembly according to an embodiment of the present disclosure;
FIG. 2 is a perspective view of a capacitor and power device assembly according to an embodiment of the present disclosure;
FIG. 3 is a perspective view of a capacitor and power device assembly according to an embodiment of the present disclosure;
FIG. 4 is a top view of a capacitor and power device assembly according to an embodiment of the present disclosure;
FIG. 5 is a bottom view of a capacitor and power device assembly according to an embodiment of the present disclosure;
FIG. 6 is a bottom view of a casing according to an embodiment of the present disclosure;
FIG. 7 is a transverse sectional view of a capacitor and power device assembly according to an embodiment of the present disclosure; and
FIG. 8 is a longitudinal sectional view of the capacitor and power device assembly according to an embodiment of the present disclosure.

In the drawings: 1. upper cover plate, 2. casing, 3. lower cover plate, 4. first liquid inlet, 5. first liquid outlet, 6. separation ridge, 7. first liquid inlet cooling passage, 8. first liquid outlet cooling passage, 9. coolant tank, 10. second liquid inlet, 11. second liquid outlet, 12. communicating inlet passage, 13. communicating outlet passage, 14. pressure relief port, 15. screw hole, 16. positioning hole.

### DETAILED DESCRIPTION

In order to make the objectives, technical solutions, and advantages of the present disclosure clearer, the technical solutions of the present disclosure will be described clearly and completely in conjunction with specific embodiments of the present disclosure and corresponding drawings. Obviously, the embodiments described herein are only part of the embodiments of the present disclosure, rather than all of the embodiments. Based on the embodiments in the present disclosure, all other embodiments obtained by a person of ordinary skill in the art without paying creative work shall fall within the protection scope of the present disclosure.

The technical solutions of embodiments of the present disclosure will be described in detail below in conjunction with the accompanying drawings.

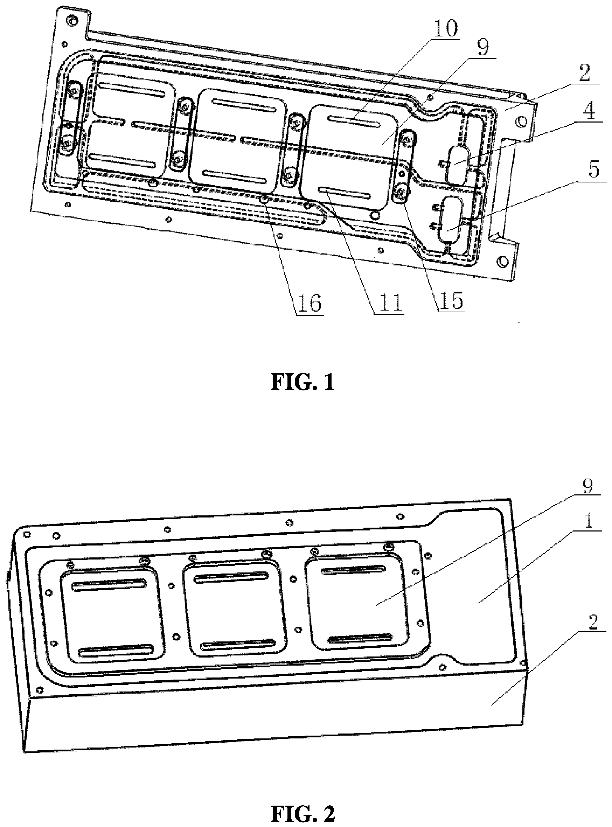

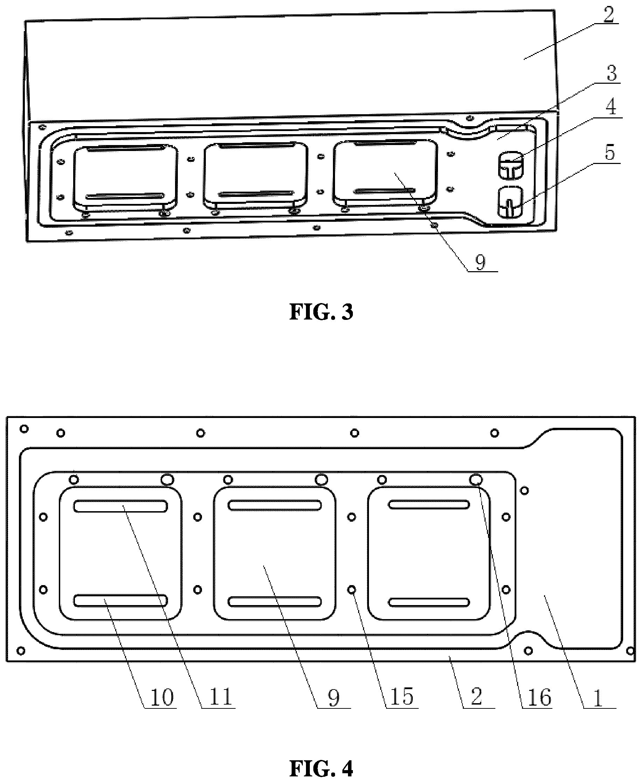

An embodiment of the present disclosure discloses a capacitor and power device assembly having a cooling structure. As shown in FIGS. 1-3, the capacitor and power device assembly comprises an upper cover plate 1, a casing 2, a lower cover plate 3, a capacitor and power devices. The casing at least comprises four side plates arranged in the vertical direction, and may further comprise two bottom plates, i.e., an upper bottom plate and a lower bottom plate. The capacitor is disposed in a cavity of the casing 2, and the upper and lower sides of the casing are provided with recesses. The upper cover plate 1 and the lower cover plate 3 are respectively disposed in the recesses. The power devices are respectively disposed on outer sides of the upper cover plate 1 and the lower cover plate 3, and the number thereof can be adjusted as required.

The cooling structure comprises a first liquid inlet 4 and a first liquid outlet 5 that are disposed on the upper cover plate 1 and/or the lower cover plate 3. The first liquid inlet 4 and the first liquid outlet 5 can be arranged separately or adjacent to each other. The positions of the first liquid inlet 4 and the first liquid outlet 5 can be adjusted according to structural requirements, for example, the first liquid inlet 4 and the first liquid outlet 5 are disposed at one end of the lower cover plate 3. The cooling structure further comprises a first cooling passage and a second cooling passage respectively disposed on upper and lower sides of each of the upper cover plate 1 and the lower cover plate 3. The first cooling passage is configured to cool the capacitor, and the second cooling passage is configured to cool the power devices. The coolant enters from the first liquid inlet 4, flows through the first cooling passage and the second cooling passage, and then flows out from the first outlet 5. The coolant may be water or oil, or other coolants.

In sum, the cooling structure in this embodiment adopts the liquid cooling mode. By providing the first cooling passage on both sides of the capacitor, the double side cooling of the capacitor is realized, and the cooling efficiency is high. Moreover, the cooling structure is also provided with a second cooling passage for cooling the power devices. Since the power devices are laid on both sides of the capacitor, the capacitor and power devices can be cooled simultaneously, and the space occupied is small, the structure is compact, which indirectly improves the power density of the motor controller.

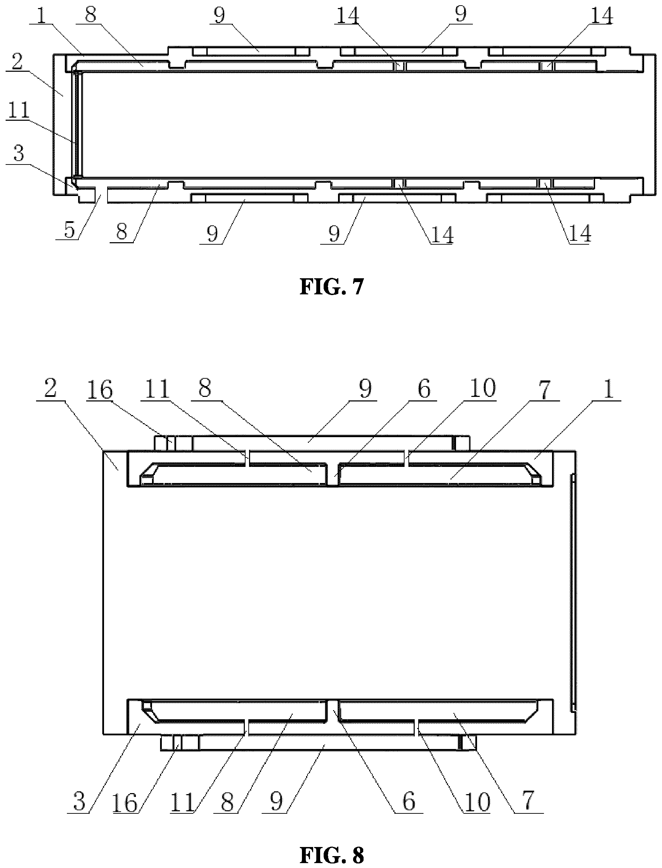

In an embodiment, the first cooling passage is disposed between the upper bottom plate of the casing 2 and the upper cover plate 1 and between the lower bottom plate of the casing 2 and the lower cover plate 3. Of course, the first cooling passage may also be disposed inside the lower side of the upper cover plate 1 or inside the upper side of the lower cover plate 3. The length and width of the first cooling passage are close to the length and width of the upper cover plate 1 and the lower cover plate 3, so that the coolant in the first cooling passage has a great contact area with the casing 2, thereby further improving the heat dissipation efficiency. The first cooling passage comprises separation ridges 6 that are provided between the casing 2 and the upper cover plate 1 and between the casing 2 and the lower cover plate 3 respectively, and extend in the length direction. As shown in FIG. 8, the separation ridges 6 divide the first cooling passage into a first liquid inlet cooling passage 7 and a first liquid outlet cooling passage 8. The first liquid inlet cooling passage 7 and the first liquid outlet cooling passage 8 are connected with the first liquid inlet 4 and the first liquid outlet 5 respectively. The separation ridges 6 may be provided on the upper and lower bottom plates of the casing 2, or on the inner side surfaces of the upper cover plate 1 and the lower cover plate 3.

In an embodiment, as shown in FIGS. 1-5 and 8, the second cooling passage comprises a number of coolant tanks 9 disposed on outer surfaces of the upper cover plate 1 and the lower cover plate 3 and at positions corresponding to positions of the power devices. The coolant tank 9 and the bottom of the power device form a cooling cavity, which can realize the cooling of the power device. A second liquid inlet 10 communicated with the first liquid inlet cooling passage 7 and a second liquid outlet 11 communicated with the first liquid outlet cooling passage 8 are provided on the bottom of each of the coolant tanks 9. The coolant in the first liquid inlet cooling passage 7 enters the coolant tank 9 from the second liquid inlet 10, and the coolant in the coolant tank 9 enters the first liquid outlet cooling passage 8 from the second liquid outlet 11 after heat exchange with the power device.

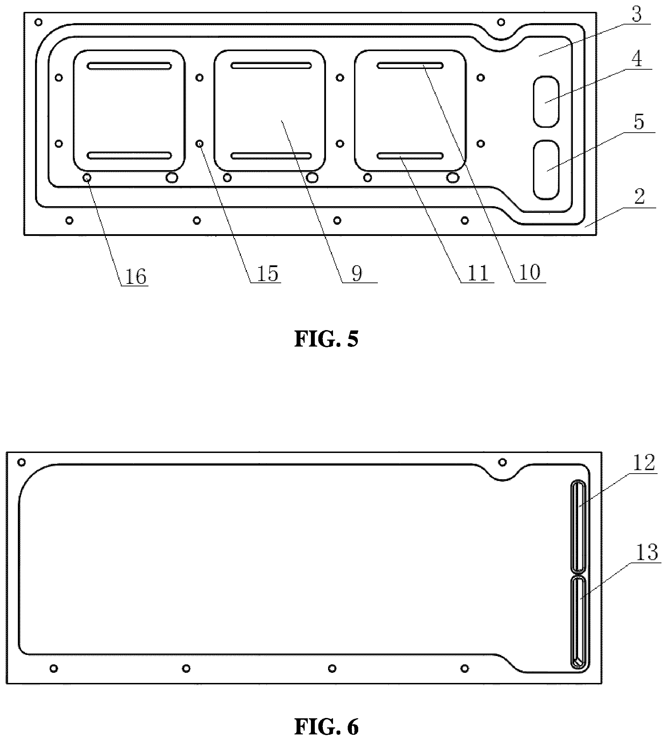

Preferably, as shown in FIGS. 6-7, the side plates of the casing 2 are provided with a communicating inlet passage 12 and a communicating outlet passage 13 that penetrate through the casing 2, which are configured to communicate the first cooling passage on the upper cover plate 1 with the first cooling passage on the lower cover plate 3, so that the coolant in the first cooling passage on the upper cover plate 1 and the first cooling passage on the lower cover plate 3 use the same liquid inlet and outlet. In order to ensure that the coolant flows smoothly from the first liquid inlet 4 into the first cooling passage on the upper cover plate 1 and the first cooling passage on the lower cover plate 3, and then flows out from the first liquid outlet 5, the positions of the communicating inlet passage 12 and the communicating outlet passage 13 correspond to the positions of the first liquid inlet 4 and the first liquid outlet 5.

In a preferred embodiment, as shown in FIG. 7, a number of pressure relief ports 14 are provided on the separation ridges 6 to directly communicate the first liquid inlet cooling passage 7 with the first liquid outlet cooling passage 8. The coolant needs to be pressurized into the cooling structure, and the pipeline in the cooling structure is relatively narrow, so the coolant will have a high pressure drop during flowing in the pipeline, which affects the smooth flow of the coolant in the cooling structure. Therefore, by providing the pressure relief ports 14 on the separation ridges 6 to reduce the pressure drop of the coolant between the first liquid inlet cooling passage 7 and the first liquid outlet cooling passage 8, the coolant can flow smoothly.

Preferably, the outer sides of the upper cover plate 1 and the lower cover plate 3 are respectively provided with three coolant tanks 9.

Preferably, as shown in FIG. 8, when three coolant tanks 9 are provided on the outer sides of the upper cover plate 1 and the lower cover plate 3 respectively, in order to reduce the pressure drop in the cooling structure to an optimal extent, the pressure relief ports 14 are respectively provided on the separating ridge 6 below two of the coolant tanks 9 on the upper cover plate 1 that are far from the first liquid inlet 4 and the first liquid outlet 5, and the pressure relief ports 14 are respectively provided on the separating ridge 6 below two of the coolant tanks 9 on the lower cover plate 3 that are far from the first liquid inlet 4 and the first liquid outlet 5.

In an embodiment, in order to realize the sealing between the power devices and the coolant tanks 9, a sealing ring is provided between each of the power devices and the corresponding coolant tank 9.

In an embodiment, as shown in FIG. 1 and FIGS. 4-5, a number of screw holes 15 are provided on the periphery of the coolant tanks 9. The power devices are connected with the upper cover plate 1 and the lower cover plate 3 respectively via screws and the screw holes 15. The number and positions of screw holes 15 can be adjusted as required. A positioning hole 16 is provided on a side of the coolant tank 9 for positioning and installation of the power device.

In an embodiment, the upper cover plate 1 and the lower cover plate 3 are connected with the casing 2 by friction stir welding, so as to realize the sealing connection of the casing 2 with the upper cover plate 1 and the lower cover plate 3 respectively.

When the first liquid inlet 4 and the first liquid outlet 5 are provided at one end of the lower cover plate 3, the coolant flow path in the cooling structure is as follows:
The coolant enters from the first liquid inlet 4 and is then divided into two paths. In one path, the coolant enters the first liquid inlet cooling passage 7 between the lower cover plate 3 and the casing 2, wherein a part of the coolant enters the coolant tanks 9 from the second liquid inlets 10, and then flows into the first liquid outlet cooling passage 8 from the second liquid outlets 11, and a part of the coolant flows directly into the first liquid outlet cooling passage 8 through the pressure relief ports 14, the coolant in the first liquid outlet cooling passage 8 flows out through the first liquid outlet 5. In the other path, the coolant enters the first coolant inlet cooling passage 7 between the upper cover plate 1 and the casing 2 via the communicating inlet passage 12, and flows out via the communicating outlet passage 13 and the first outlet 5 after circulating cooling.

## Claims

1. A capacitor and power device assembly having a cooling structure, wherein the capacitor and power device assembly comprises an upper cover plate (1), a casing (2), a lower cover plate (3), a capacitor and power devices, the capacitor is disposed in a cavity of the casing (2), and the power devices are respectively disposed on outer sides of the upper cover plate (1) and the lower cover plate (3);
the cooling structure comprises a first liquid inlet (4) and a first liquid outlet (5) that are disposed on the upper cover plate (1) and/or the lower cover plate (3); and
the cooling structure further comprises a first cooling passage and a second cooling passage that are respectively disposed on upper and lower sides of each of the upper cover plate (1) and the lower cover plate (3), the first cooling passage is configured to cool the capacitor, and the second cooling passage is configured to cool the power devices;
the first cooling passage is respectively disposed between an upper bottom plate of the casing (2) and the upper cover plate (1) and between or a lower bottom plate of the casing (2) and the lower cover plate (3); and
the first cooling passage comprises separation ridges (6) disposed at a middle position of the first cooling passage and extending in a length direction of the casing (2), and the separation ridges (6) divide the first cooling passage into a first liquid inlet cooling passage (7) and a first liquid outlet cooling passage (8);
the second cooling passage comprises a number of coolant tanks (9) disposed on outer surfaces of the upper cover plate (1) and the lower cover plate (3) and at positions corresponding to positions of the power devices; and
a bottom of the coolant tank (9) is provided with a second liquid inlet (10) communicated with the first liquid inlet cooling passage (7) and a second liquid outlet (11) communicated with the first liquid outlet cooling passage (8).

2. The capacitor and power device assembly according to claim 1, wherein outer sides of the upper cover plate (1) and the lower cover plate (3) are respectively provided with three coolant tanks (9).

3. The capacitor and power device assembly according to claim 2, wherein pressure relief ports (14) are respectively provided on the separation ridge (6) below two of the coolant tanks (9) on the upper cover plate (1) that are far from the first liquid inlet (4) and the first liquid outlet (5), and pressure relief ports (14) are respectively provided on the separation ridge (6) below two of the coolant tanks (9) on the lower cover plate (3) that are far from the first liquid inlet (4) and the first liquid outlet (5).

4. The capacitor and power device assembly according to claim 3, wherein a sealing ring is disposed between each of the power devices and the corresponding coolant tank (9).

5. The capacitor and power device assembly according to claim 3, wherein a number of screw holes (15) are provided on a periphery of the coolant tanks (9), and the power devices are connected with the upper cover plate (1) and the lower cover plate (3) via screws and the screw holes (15).

## Patentansprüche

1. Kondensator- und Leistungsvorrichtungsanordnung mit einem Kühlaufbau, wobei die Kondensator- und Leistungsvorrichtungsanordnung eine obere Abdeckplatte (1), ein Gehäuse (2), eine untere Abdeckplatte (3), einen Kondensator und Leistungsvorrichtungen umfasst, wobei der Kondensator in einem Hohlraum des Gehäuses (2) angeordnet ist und die Leistungsvorrichtungen jeweils auf Außenseiten der oberen Abdeckplatte (1) und der unteren Abdeckplatte (3) angeordnet sind;
der Kühlaufbau einen ersten Flüssigkeitseinlass (4) und einen ersten Flüssigkeitsauslass (5) umfasst, die auf der oberen Abdeckplatte (1) und/oder der unteren Abdeckplatte (3) angeordnet sind; und
der Kühlaufbau ferner einen ersten Kühlkanal und einen zweiten Kühlkanal umfasst, die jeweils auf oberen und unteren Seiten von jeder der oberen Abdeckplatte (1) und der unteren Abdeckplatte (3) angeordnet sind, wobei der erste Kühlkanal konfiguriert ist, um den Kondensator zu kühlen, und der zweite Kühlkanal konfiguriert ist, um die Leistungsvorrichtungen zu kühlen; der erste Kühlkanal jeweils zwischen einer oberen Bodenplatte des Gehäuses (2) und der oberen Abdeckplatte (1) und zwischen oder einer unteren Bodenplatte des Gehäuses (2) und der unteren Abdeckplatte (3) angeordnet ist; und
der erste Kühlkanal Trennrippen (6) umfasst, die an einer mittleren Position des ersten Kühlkanals angeordnet sind und sich in einer Längsrichtung des Gehäuses (2) erstrecken, und die Trennrippen (6) den ersten Kühlkanal in einen Kühlkanal (7) des ersten Flüssigkeitseinlasses und einen Kühlkanal (8) des ersten Flüssigkeitsauslasses unterteilen;
der zweite Kühlkanal eine Anzahl von Kühlmitteltanks (9) umfasst, die auf Außenflächen der oberen Abdeckplatte (1) und der unteren Abdeckplatte (3) und an Positionen angeordnet sind, die Positionen der Leistungsvorrichtungen entsprechen; und
ein Boden des Kühlmitteltanks (9) mit einem zweiten Flüssigkeitseinlass (10), der mit dem Kühlkanal (7) des ersten Flüssigkeitseinlasses in Verbindung steht, und einem zweiten Flüssigkeitsauslass (11), der mit dem Kühlkanal (8) des ersten Flüssigkeitsauslasses in Verbindung steht, versehen ist.

2. Kondensator- und Leistungsvorrichtungsanordnung nach Anspruch 1, wobei Außenseiten der oberen Abdeckplatte (1) und der unteren Abdeckplatte (3) jeweils mit drei Kühlmitteltanks (9) versehen sind.

3. Kondensator- und Leistungsvorrichtungsanordnung nach Anspruch 2, wobei Druckentlastungsöffnungen (14) jeweils an der Trennrippe (6) unterhalb von zwei der Kühlmitteltanks (9) an der oberen Abdeckplatte (1) vorgesehen sind, die weit von dem ersten Flüssigkeitseinlass (4) und dem ersten Flüssigkeitsauslass (5) entfernt sind, und Druckentlastungsöffnungen (14) jeweils an der Trennrippe (6) unterhalb von zwei der Kühlmitteltanks (9) an der unteren Abdeckplatte (3) vorgesehen sind, die weit von dem ersten Flüssigkeitseinlass (4) und dem ersten Flüssigkeitsauslass (5) entfernt sind.

4. Kondensator- und Leistungsvorrichtungsanordnung nach Anspruch 3, wobei ein Dichtungsring zwischen jeder der Leistungsvorrichtungen und dem entsprechenden Kühlmitteltank (9) angeordnet ist.

5. Kondensator- und Leistungsvorrichtungsanordnung nach Anspruch 3, wobei eine Anzahl von Schraubenlöchern (15) an einem Umfang der Kühlmitteltanks (9) vorgesehen sind und die Leistungsvorrichtungen mit der oberen Abdeckplatte (1) und der unteren Abdeckplatte (3) über Schrauben und die Schraubenlöcher (15) verbunden sind.

## Revendications

1. Ensemble condensateur et dispositif de puissance ayant une structure de refroidissement,
dans lequel l'ensemble condensateur et dispositif de puissance comprend une plaque de couverture supérieure (1), un boîtier (2), une plaque de couverture inférieure (3), un condensateur et des dispositifs de puissance, le condensateur est disposé dans une cavité du boîtier (2), et les dispositifs de puissance sont respectivement disposés sur les côtés extérieurs de la plaque de couverture supérieure (1) et de la plaque de couverture inférieure (3) ;
la structure de refroidissement comprend une première entrée de liquide (4) et une première sortie de liquide (5) qui sont disposées sur la plaque de couverture supérieure (1) et/ou la plaque de couverture inférieure (3) ; et
la structure de refroidissement comprend en outre un premier passage de refroidissement et un deuxième passage de refroidissement qui sont respectivement disposés sur les côtés supérieur et inférieur de chacune de la plaque de couverture supérieure (1) et la plaque de couverture inférieure (3), le premier passage de refroidissement est configuré pour refroidir le condensateur, et le deuxième passage de refroidissement est configuré pour refroidir les dispositifs de puissance ;
le premier passage de refroidissement est respectivement disposé entre une plaque de fond supérieure du boîtier (2) et la plaque de couverture supérieure (1) et entre ou une plaque de fond inférieure du boîtier (2) et la plaque de couverture inférieure (3) ; et
le premier passage de refroidissement comprend des nervures de séparation (6) disposées à une position médiane du premier passage de refroidissement et s'étendant dans une direction longitudinale du boîtier (2), et les nervures de séparation (6) divisent le premier passage de refroidissement en un premier passage de refroidissement d'entrée de liquide (7) et un premier passage de refroidissement de sortie de liquide (8) ;
le deuxième passage de refroidissement comprend un certain nombre de réservoirs de liquide de refroidissement (9) disposés sur les surfaces extérieures de la plaque de couverture supérieure (1) et de la plaque de couverture inférieure (3) et à des positions correspondant aux positions des dispositifs de puissance ; et
un fond du réservoir de liquide de refroidissement (9) est pourvu d'une deuxième entrée de liquide (10) communiquant avec le premier passage de refroidissement d'entrée de liquide (7) et d'une deuxième sortie de liquide (11) communiquant avec le premier passage de refroidissement de sortie de liquide (8).

2. Ensemble condensateur et dispositif de puissance selon la revendication 1, dans lequel les côtés extérieurs de la plaque de couverture supérieure (1) et de la plaque de couverture inférieure (3) sont respectivement pourvus de trois réservoirs de liquide de refroidissement (9).

3. Ensemble condensateur et dispositif de puissance selon la revendication 2, dans lequel des orifices de décompression (14) sont respectivement prévus sur la nervure de séparation (6) en dessous de deux des réservoirs de liquide de refroidissement (9) sur la plaque de couverture supérieure (1) qui sont éloignés de la première entrée de liquide (4) et de la première sortie de liquide (5), et des orifices de décompression (14) sont respectivement prévus sur la nervure de séparation (6) en dessous de deux des réservoirs de liquide de refroidissement (9) sur la plaque de couverture inférieure (3) qui sont éloignés de la première entrée de liquide (4) et de la première sortie de liquide (5).

4. Ensemble condensateur et dispositif de puissance selon la revendication 3, dans lequel une bague d'étanchéité est disposée entre chacun des dispositifs de puissance et le réservoir de liquide de refroidissement correspondant (9).

5. Ensemble condensateur et dispositif de puissance selon la revendication 3, dans lequel un certain nombre de trous de vis (15) sont prévus sur une périphérie des réservoirs de liquide de refroidissement (9), et les dispositifs de puissance sont reliés à la plaque de couverture supérieure (1) et à la plaque de couverture inférieure (3) via des vis et les trous de vis (15).
